# EUROPEAN PATENT APPLICATION

(11) **EP 1 840 980 A1**
(43) Date of publication of application: **03.10.2007**
(21) Application number: 06425225.7
(22) Date of filing: 31.03.2006
(51) Int. Cl.: H01L 35/32, H01L 23/38, C12M 1/38

(54) **Structure comprising Peltier cells integrated on a semiconductor substrate and corresponding manufacturing process**

(71) Applicant: STMicroelectronics S.r.l., 20041 Agrate Brianza (Milano) (IT)
(72) Inventor: Crocifisso, Marco Antonio, 93012 Gela (CL) (IT); Coffa, Salvatore, 95030 Tremestieri Etneo (CT) (IT)
(74) Representative: Ferrari, Barbara

(57) **Abstract**

Structure (10) integrated on a semiconductor substrate (11) comprising at least one elementary Peltier cell which comprises:
a conductive region (15) formed in the semiconductor substrate (11) being less resistive with respect to the semiconductor substrate (11),
a first semiconductive region (19) projecting from the semiconductor substrate (11) in electric contact with the conductive region (15),
a second semiconductive region (23) projecting from the semiconductor substrate (11) in electric contact with the conductive region (15) and spaced from the first semiconductive region (19), the first semiconductive region (19) and the second semiconductive region (23) having different type of conductivity.

## Description

### Field of application

The present invention relates to a structure comprising a Peltier cell integrated on a semiconductor substrate and relative manufacturing process.

More specifically, the invention relates to a structure integrated on a semiconductor substrate comprising at least one elementary Peltier cell.

The invention particularly, but not exclusively, relates to a device comprising Peltier cells for cooling and/or warming, in an efficient way, a semiconductor substrate and the following description is made with reference to this field of application by way of illustration only.

### Prior art

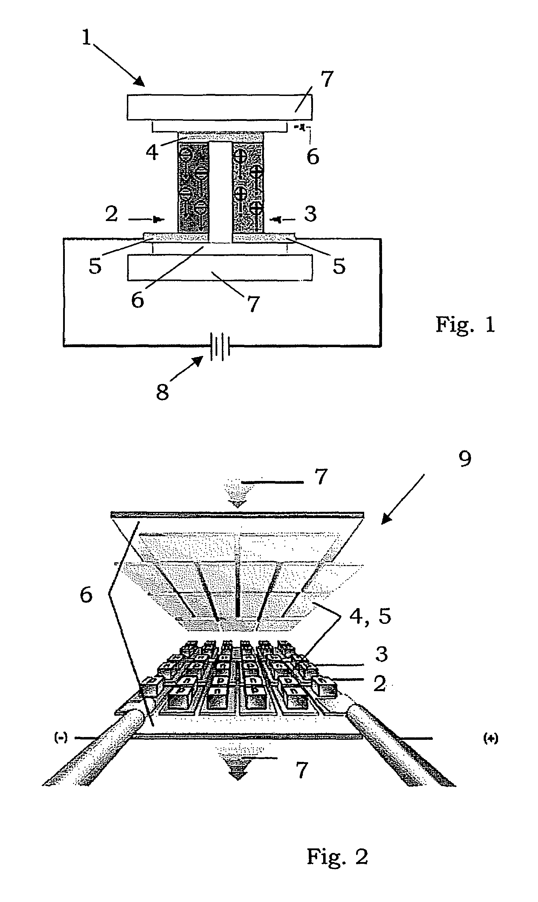

As it is well known, a Peltier cell, like the one shown in Figure 1, is formed by two blocks 2, 3 of semiconductor material, respectively doped of the N type and of the P type, wherein first ends of the two blocks 2, 3 of semiconductor material are connected to each other by a bar 4 of metal for example of copper. A source 8 in continuous current (DC) is then connected to respective second ends of the two blocks 2, 3 of semiconductor material through the interposition of a respective layer 5 of metal for example of copper.

The Peltier cell 1 is then completed by layers 6 of electrically insulating, but good heat conductor, material and heat sinks stacked on the bar 4 of copper and on the layers 5 of copper.

If a positive voltage is applied to the block 2 of the N type and a negative voltage is applied to the block 3 of the P type, the bar 4 of copper cools down, while the layers 5 of copper warm up. If the biasing is inverted and the block 2 of the N type is supplied with a negative voltage and the block 3 of the P type with a positive voltage the operation of the cell 1 is inverted and the bar 4 warms up and the layers 5 cool down.

The operation of the Peltier cell is based on the Peltier effect which is exactly opposed to the thermoelectric effect known as Seeback effect. Through the Peltier effect an electric current "crossing" two conductor materials electrically connected to each other, for example welded in case of metallic materials, generates a difference of temperature, on the contrary, a difference of temperature across the two metals welded to each other generates a thermoelectric current (Seedback effect).

In the case of the Peltier effect it is understood that the amount of heat generated in the welds is directly proportional to the intensity of the electric current crossing them.

Peltier cells are currently used mainly in refrigerating systems. Naturally, one of the heat sinks 7 of the Peltier cell must be placed on the surface which must be warmed or cooled. To increase the efficiency of the Peltier cell a structure 9 is resorted to, like the one shown in figure 2.

This structure 9 comprises a plurality of elementary Peltier cells 1 which are electrically connected in series and thermally in parallel.

Although this structure 9 is advantageous under several aspects it shows various drawbacks.

In particular, the different assembling steps of the structure 9 imply a remarkable increase of the costs, thus discouraging the use of these cooling/warming systems in the consumer market.

The technical problem underlying the present invention is that of providing a structure comprising at least one Peltier cell and relative manufacturing process, having such structural and functional characteristics as to allow to remarkably reduce the manufacturing costs of the single Peltier cells which constitute the structure and to increase its their reliability, overcoming the limits and the drawbacks still limiting the Peltier cells manufactured according to the prior art.

### Summary of the invention

The solution idea underlying the present invention is that of integrating a structure comprising at least one elementary Peltier cell on the same substrate to be cooled/warmed.

On the basis of this solution idea the technical problem is solved by a structure of the type as previously indicated and defined by the characterising part of claim 1.

The problem is also solved by a process as previously indicated and defined by the characterising part of claim 8.

The characteristics and the advantages of the structure according to the invention will be apparent from the following description of an embodiment thereof given by way of indicative and non limiting example made with reference to the annexed drawings.

### Brief description of the drawings

In these drawings:
figure 1 shows the functional scheme of an elementary Peltier cell according to the prior art,
figure 2 shows the structure comprising Peltier cells manufacured according to the prior art, obtained through the assembly of small blocks of semiconductor of the P and N type, alternated and connected by means of metallic elements,
figures 3 to 18 show several steps of the process for obtaining the structure of Peltier cells according to the invention,
figure 19 shows a section view of the structure comprising Peltier cells according to the invention,
figure 20 shows a photograph, taken from a SEM electronic microscope, of a vertical section of the structure according to the invention at the end of the process step shown in figure 10,
figures 21, 22 and 23 show three different embodiments of a structure comprising Peltier cells integrated on semiconductor substrates and manufactured with the process according to the invention,
figure 24 shows the example of a PCR structure comprising a structure comprising Peltier cells according to the invention.

### Detailed description

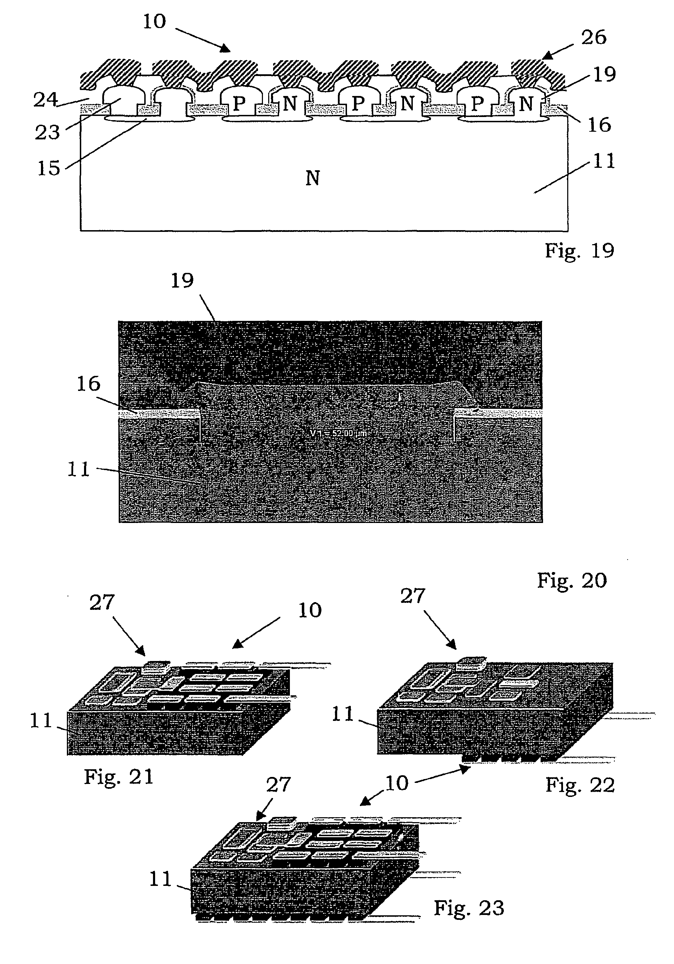

With reference to figure 19, a structure 10 is described comprising Peltier cells integrated on a semiconductor substrate 11.

In particular, the structure 10 integrated on the semiconductor substrate 11, for example of the N type, comprises at least one elementary Peltier cell which comprises:
- a conductive region 15, for example of the P or N type, formed in the semiconductor substrate 11 which is less resistive than the semiconductor substrate 11,
- a first semiconductive region 19, for example of the N type, projecting from the semiconductor substrate 11 in electric contact with said conductive region 15,
- a second semiconductive region 23, for example of the P type, projecting from the semiconductor substrate in electric contact with the conductive region 15 and spaced from the first semiconductive region 19.

Advantageously, the first and the second semiconductive region 19, 23 have the form of strips or small blocks whose vertical section has a mushroom-like shape, i.e. it has a first lower portion with substantially vertical side walls and a second upper portion being dome-like shaped.

In particular, according to the invention, the conductive region 15 forms a first junction of the elementary Peltier cell.

A second junction of the elementary Peltier cell is formed by means of a conductive layer 26, for example metallic, in electric contact with the first and the second semiconductive region 19, 23.

Advantageously, in the structure 10 according to the invention portions of the metallic layer 26 electrically connect a first and a second semiconductive region 19, 23 which contact adjacent conductive regions 15, so that the elementary Peltier cells of the structure 10 according to the invention are electrically in series and thermally in parallel through two conductor levels, the first one formed by the conductive regions 15 of the semiconductor substrate 11 and the second one by the metallic layer 26.

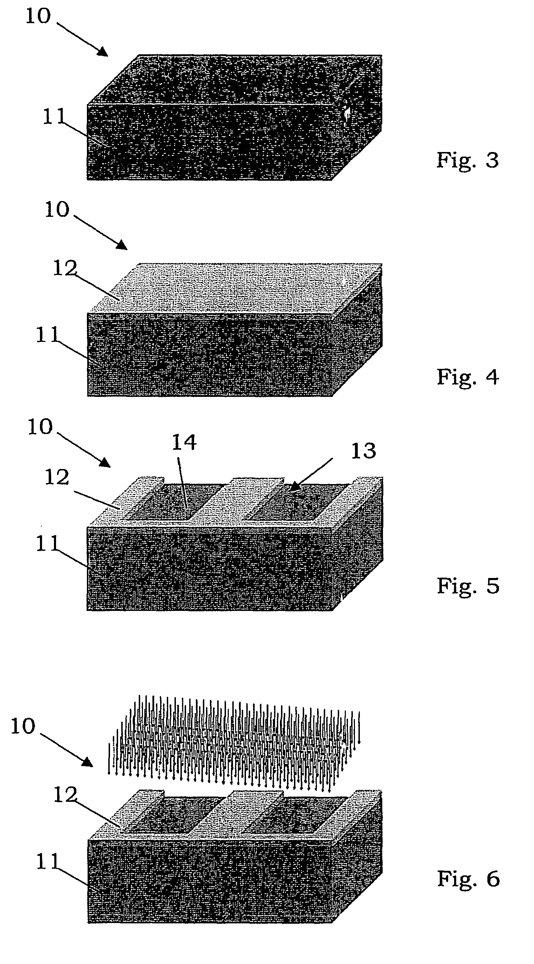

With reference to figures 3 to 18, the process according to the invention is now described for integrating a structure 10 comprising a plurality of Peltier cells on any one or on both the surfaces of the semiconductor substrate 11.

For simplifying the description, the process for integrating a structure 10 comprising a plurality of Peltier cells on an upper surface of a semiconductor substrate 11 is described.

The structure 10 is not prevented from comprising a single elementary cell.

Advantageously, the semiconductor substrate 11 is comprised in a silicon wafer of any diameter and thickness manufactured both through CZ technique (Czochralski crystal technique) and FZ technique (float-zone crystal growth). Advantageously, silicon wafers are used with crystallographic orientation according to Miller <100>. In fact, some epitaxial growth techniques which can be used in the process according to the invention do not allow the use of crystals <111>.

In case the structure 10 comprising at least one Peltier cell is to be manufactured on the back or on both the surfaces of the semiconductor substrate 11, both the surfaces of the semiconductor substrate 11 must be lapped, i.e. of the double bright type.

The thickness of the semiconductor substrate 11 depends on the geometry, besides the amount, of heat it will have to exchange and thus on the type of application wherein a structure 10 according to the invention will be used.

Advantageously, the semiconductor substrate 11 is of the p type or of the n type, for example with a resistivity being, at the most, in the order of some Ω*cm.

Advantageously, in the process according to the invention a cleaning step of the semiconductor substrate 11 is carried out to remove organic materials and dust residues (specle) from the surface whereon the structure 10 according to the invention will be formed.

A first insulating layer 12 is then formed on the semiconductor substrate 11, as shown in figure 4.

Advantageously, this first insulating layer 12 is a silicon dioxide layer formed through a thermal oxidation step of the upper surface of the semiconductor substrate 11.

Through a lithography process and successive etching step, in this first insulating layer 12 first openings 13 are formed which leave first portions 14 of semiconductor substrate 11 exposed, as shown in figure 5.

In particular, in each of these first portions 14 of semiconductor substrate 11 a portion of an elementary Peltier cell of the structure 10 according to the invention will be formed.

Advantageously, the first portions 14 of semiconductor substrate 11 have a substantially rectangular shape.

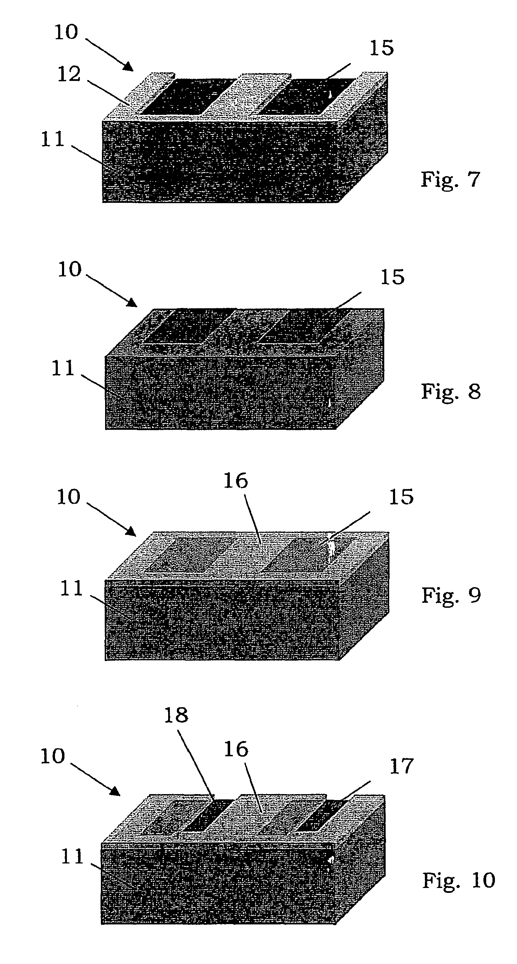

Subsequently, as shown in figure 7, in these first portions 14 of semiconductor substrate 11 conductive regions 15 are formed having a lower resistivity than that of the semiconductor substrate 11, being comparable to the one of a metallic layer, for example, below some mΩ*cm.

In particular, according to the invention, the conductive regions 15 form a first junction of the elementary Peltier cells of the structure 10 according to the invention.

Advantageously, the semiconductor substrate 11 is chosen with a resistivity of at least two more orders of magnitude with respect to the resistivity of the conductive regions 15.

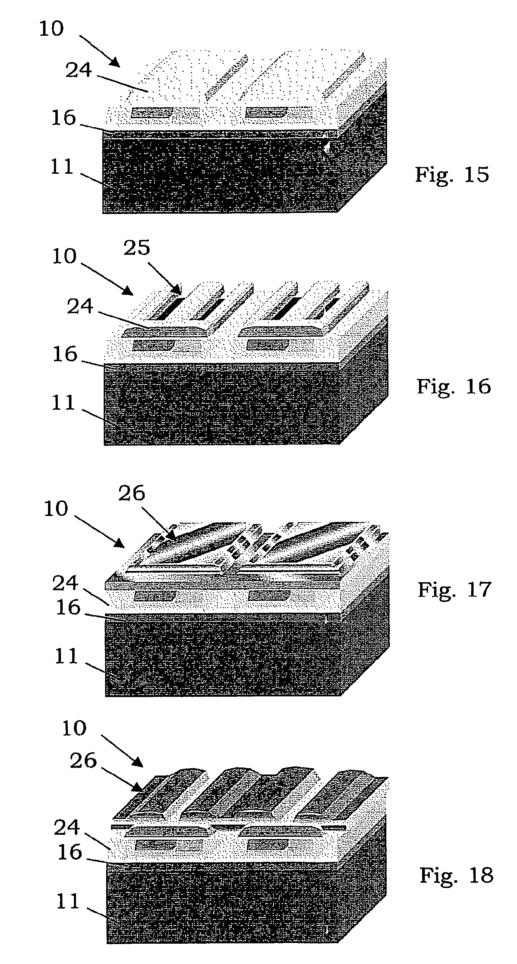

Advantageously, these conductive regions 15 are manufactured by means of a first ionic implantation step with high dose of dopant of the N type, for example Arsenic or Phosphorus since they have a limited diffusivity, in the case of semiconductor substrate 11 of the n type and of dopant of the P type, for example Boron, if instead the semiconductor substrate 11 is of the p type. As it is known the implanted ions will introduce themselves into the crystalline reticule only in the first exposed portions 14 of semiconductor substrate 11. The remaining ions will remain entrapped in the first insulating layer 12 shielding the semiconductor substrate 11, as shown in figure 16.

The conductive regions 15 are not prevented from being of opposite concentration to that of the semiconductor substrate 11, provided that they are rather conductive, i.e. as much similar as possible to a metallic layer, for example with a concentration of about 1x10²⁰ cm⁻³.

The first insulating layer 12 is then removed, as shown in figure 8.

If the first insulating layer 12 is formed by a silicon oxide layer, this removal step is for example carried out by means of a wet etching step in aqueous solution of hydrofluoric acid.

A thermal process is carried out for rearranging the crystalline structure of the semiconductor substrate 11 which has been damaged during the firs implant step.

Advantageously, this thermal process is a thermal process in nitrogen with high temperature or an RTA (Rapid Thermal Annealing) is carried out. During this thermal process also the activation and the diffusion of the conductive regions 15 occurs.

A second insulating layer 16 is then formed on the surface of the semiconductor substrate 11, as shown in figure 9.

Advantageously, this second insulating layer 16 is a stoichiometric thermal oxide layer formed by means of a thermal growth step.

Advantageously, this stoichiometric thermal oxide layer is formed after the thermal process necessary to rearrange the crystalline structure of the semiconductor substrate 11 so that this second insulating layer 16 is as much defectless as possible.

The activation/diffusion step of the implanted species of the conductive regions 15 is not prevented from being combined with the same growth process of the thermal oxide layer.

By means of a second photolithographic process and the successive etching, second windows 17 are opened in the second insulating layer 16 which leave second portions 18 of semiconductor substrate 11 exposed.

Advantageously, second portions 18 of semiconductor substrate 11 are totally comprised inside the conductive regions 15, as shown in figure 10.

Advantageously, the second portions 18 of semiconductor substrate 11 have a substantially rectangular shape.

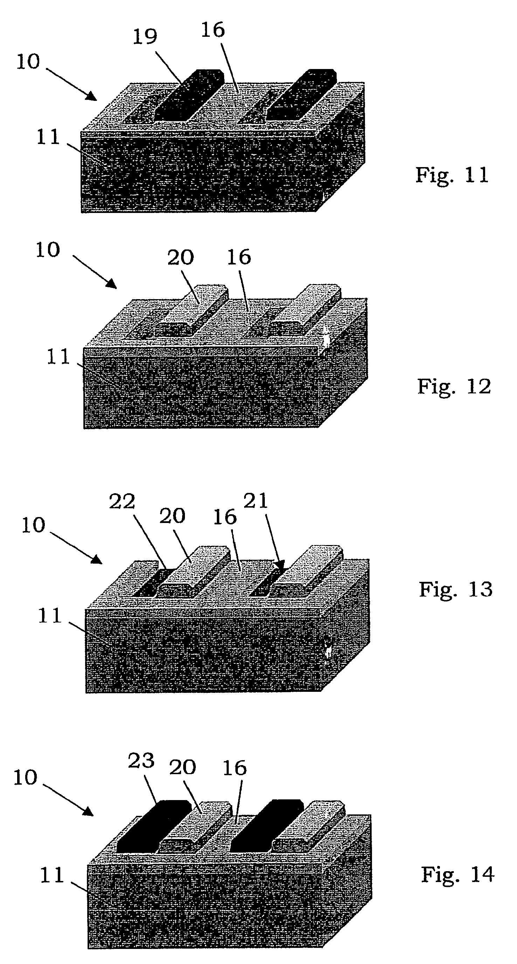

At this point, above each one of the second portions 18 of semiconductor substrate 11, first semiconductive regions 19 are formed projecting from the semiconductor substrate 11, as shown in figure 11.

Advantageously, the first semiconductive regions 19 are of the N type with a concentration comprised in the range between 1x10¹³ and 1x10¹⁸ cm⁻³.

Advantageously, the first semiconductive regions 19 are strips or semiconductor blocks completely covering the second portions 18 of semiconductor substrate 11.

Advantageously, these first semiconductive regions 19 are formed by means of a first epitaxial growth step selective with respect to the second insulating layer 16, therefore the growth of these first semiconductive regions 19 will occur only on those second portions 18 of semiconductor substrate 11 and not on the second insulating layer 16.

In an embodiment shown in figure 19, the semiconductive regions 19 are formed also on a portion of the second insulating layer 16 which surrounds second windows 17, thereby these semiconductive regions 19 show a vertical section being mushroom-like shaped, i.e. with a first lower portion having substantially vertical side walls and a second upper portion being dome-like shaped whose edge portions are formed on the second insulating layer.

Figure 20 shows a portion of the structure 10 after a growth process by means of selective epitaxy of the first semiconductive region 19. The thickness of the first semiconductive regions 19, which is comprised, for example, between some micron and some hundreds of micron and the concentration varies from 1E¹³ and 1E²⁰ at/cm³. These parameters are established according to the application and the type of the dopant is, for example, homologous to the one of the semiconductor substrate 11.

A third insulating layer 20 is then formed to coat the first semiconductive regions 19, as shown in figure 12.

Advantageously, this third insulating layer 20 is a thermal oxide layer obtained by putting the structure 10 obtained up to this point into a furnace with oxygen.

By means of a third lithography step followed by the relative etching step, third openings 21 are opened in the second insulating layer 16, as shown in figure 13, these windows leaving third portions 22 of semiconductor substrate 11 adjacent but spaced from the first semiconductive regions 19 exposed.

Advantageously, the third portions 22 of semiconductor substrate 11 are totally comprised inside the conductive regions 15.

Advantageously, the third windows 21 have the same dimensions as those of the second windows 17.

If the second insulating layer 16 is formed by a silicon dioxide layer, this latter etching step for opening the third windows 21 can be both of the wet type and of the dry type, according to the needs and to the dimensions of the windows to be opened.

Above each one of the third portions 22 of semiconductor substrate 11 second semiconductive regions 23 are formed projecting from the semiconductor substrate 11, as shown in figure 14.

According to the invention, the second semiconductive regions 23 are of a different type of dopant (of the opposed type) with respect to the one of the first semiconductive regions 19.

Advantageously, the second semiconductive regions are of the P type with a concentration comprised in the range between 1x10¹³ and 1x10¹⁸ cm⁻³.

Advantageously, these second semiconductive regions 22 are formed by means of a second selective epitaxial growth, thereby the growth of these second semiconductive regions 23 will occur only on the third portions 22 of semiconductor substrate 11 and not on the second and on the third insulating layer 16, 20, through the same modes with which the first epitaxial growth step is carried out.

Advantageously, the second semiconductive regions 23 have the same thickness, the same shape and dimensions as the first semiconductive regions 19.

At this point, after having formed the first and the second semiconductive regions 19, 23 with alternated doping, their electric passivation follows by means of the formation of a passivation layer 24 on the whole structure 10, as shown in figure 15.

The passivation layer 24 is for example a thermal oxide layer, or a dielectric layer, for example a Vapox layer (Vapour-Deposited-Oxide), a TEOS layer (Tetra Ethyl Oxysilane), a nitride layer, etc..

The process according to the invention then provides the formation of a second junction layer between the first and the second semiconductive regions 19, 23, a first junction layer being formed by the conductive regions 15.

In particular, by means of a fourth lithography step carried followed by the relative etching step, in the passivation layer 24 and in the third insulating layer 20, where present, fourth windows 25 are opened which leave upper portions of the first and second semiconductive regions 19, 23 exposed as shown by figure 16.

Advantageously, these upper portions of the first and second semiconductive regions 19, 23 are totally comprised inside the upper surfaces of the first and second semiconductive regions 19, 23.

If the passivation layer is formed by a TEOS or Vapox layer, in general of silicon dioxide, this latter etching step can be carried out in a single solution both in wet and in dry.

On the structure 10 thus defined, a conductive layer 26 is formed, for example metallic, as shown in figure 17.

Advantageously, the metallic layer is deposited by means of sputtering or electrodeposition techniques. The thickness of this metallic layer 26 is provided on the basis of the current which will cross each elementary Peltier cell.

Figure 18 shows the complete structure 10 obtained after a fifth lithography step and the relative etching of the conductive layer 26 for obtaining portions of layer 26 electrically connected to the first and to the second semiconductive regions 19, 23.

In particular, as shown for example in figure 19, portions of the metallic layer 26 electrically connect a first and a second semiconductive region 19, 23 which respectively contact adjacent conductive regions 15, so that elementary Peltier cells of the structure 10 according to the invention are electrically in series and thermally in parallel through two conductive levels, the first one formed by the conductive regions in the semiconductive substrate 11 and the second one by the metallic layer 26.

It is important to note that the process sequence just described is not strict since some steps of the manufacturing process, such as the epitaxial growths to form the first and the second semiconductive regions 19, 23, can also be inverted. Moreover, the above described process steps can also be "diluted" inside a more complex and longer process flow. In this way, also the process steps already present in a manufacturing process flow of the known type and which thus have no cost for the manufacturing of the invention can be used, with the double advantage of a lower impact on the manufacturing process flow of the known type and a reduction of the manufacturing cost of the structure 10 according to the invention. Moreover, the integration of thermal control functions and/or a cooling system on the same semiconductor substrate 11 allows to remarkably increase the performances of an electronic device which needs such functions in terms of reliability and thermal stability so as to have also a greater economic margin on the single component without practically altering the manufacturing cost of the electronic device integrated on a semiconductor substrate.

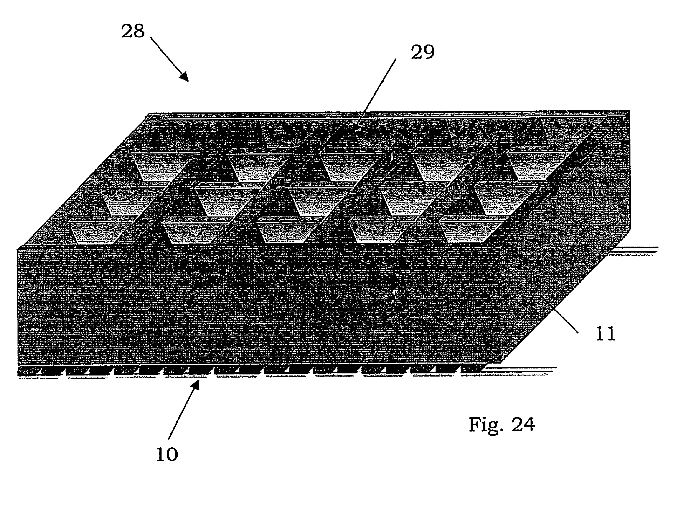

With reference to figures 21, 22, 23 and 24 some examples of integration of a structure 10 according to the invention are shown.

In particular, figure 21 shows a "top integration" configuration wherein the structure 10 and an electronic circuit 27 to be thermally treated are on the same surface of the semiconductor substrate 11; figure 22 shows instead a "bottom integration" configuration wherein the structure 10 is on the back of the semiconductor substrate 11 whereon there is the electronic circuit 27 to be thermally treated; finally, figure 23 shows a "double side integration" configuration wherein the structure 10 is distributed both on the surface and on the back of the semiconductor substrate 11.

The figure shows a PCR structure 28 (polimerase chain reaction) for applications in a biologic field, here reported only by way of example. The PCR structure 28 is completely made on the same semiconductor substrate 11, for example of silicon, wherein the elementary Peltier cells of the structure according to the invention are formed.

In particular, in a first surface of a semiconductor substrate 11 some pits 29 are formed in a known way, for example by means of a lithography step and anisotropic etching in a solution comprising potassium hydroxide (KOH) or tetra methyl ammonium hydroxide (TMAH), while on the back of the semiconductor substrate 11 the structure 10 according to the invention is formed. The structure 10 will allow the temperature variations (95°C > 54°C > 72°C) necessary to obtain the enzymatic amplification in vitro of a specific DNA sequence by the PCR structure 28.

In conclusion, the process according to the invention allows to reduce the manufacturing costs due to the use of conventional processes for manufacturing integrated circuits and to increase the reliability of a structure 10, comprising Peltier cells, forming it on the same semiconductor substrate 11 to be cooled/warmed, thus avoiding the use of assembling processes necessary for manufacturing Peltier cells of the commercial type similar to the one shown in figure 2.

In fact, the manufacturing steps of integrated circuits allow, as it is known, to have monolithic structures showing an excellent mechanical strength although using extremely thin, and thus light, substrates easy to be treated on an industrial scale and thus suitable for big volume production.

Moreover, the monolithic integration allows to form, on both the surfaces of the semiconductor substrate 11, both the structure 10 according to the invention and the electronics 27 of the circuit to be thermally controlled and also possible MEMS devices (Micro ElectroMechanical Systems) complementing the architecture in the same process flow, with all the deriving advantages in terms of semiconductor area occupation.

Advantageously, in the process according to the invention a lithographic technique is used known as "Double Side Mask Aligner", which allows to define and align structures on both the surfaces of the semiconductor substrate 11 with a micrometric precision.

Finally, the structure 10 according to the invention, being able to supply and/or absorb heat from the substrate whereon it is formed, is widely used in the field of the cooling of integrated electronic circuits, but especially in the field of chemical and biological applications and of MEMS formed on semiconductor substrates wherein variations of the temperature and/or controlled thermal cycles are necessary.

Naturally, the area of the structure 10 according to the invention, the geometry and the dimensions of the small blocks 19, 23 and the number of junctions directly depend on the thermal power it will have to handle and thus on the type of application. Moreover, the integration on a silicon semiconductor substrate 11 allows a great integration modularity, both for example of the shape and of the occupation area of the structure 10, to the advantage of a great versatility of the manufacturing processes and thus of the power required by the application.

## Claims

1. Structure (10) integrated on a semiconductor substrate (11) comprising at least one elementary Peltier cell which comprises:
- a conductive region (15) formed in the semiconductor substrate (11) being less resistive with respect to said semiconductor substrate (11),
- a first semiconductive region (19) projecting from said semiconductor substrate (11) in electric contact with said conductive region (15),
- a second semiconductive region (23) projecting from said semiconductor substrate (11) in electric contact with said conductive region (15) and spaced from said first semiconductive region (19), said first semiconductive region (19) and said second semiconductive region (23) having different type of conductivity.

2. Structure (10) integrated on a semiconductor substrate (11) according to claim 1, **characterised in that** portions of a conductive layer (26) are electrically connected to said first and second semiconductive region (19, 23).

3. Structure (10) integrated on a semiconductor substrate (11) according to claim 2, comprising a plurality of elementary Peltier cells, **characterised in that** first semiconductive regions (19) are connected to second semiconductive regions (23) which respectively contact adjacent conductive regions (15) by means of said portions of said conductive layer (26).

4. Structure (10) integrated on a semiconductor substrate (11) according to claim 1, **characterised in that** said first and second semiconductive region (19, 23) have the same dimensions.

5. Structure (10) integrated on a semiconductor substrate (11) according to claim 1, **characterised in that** said semiconductor substrate (11), said first and second semiconductor region (19, 23) are of silicon.

6. Structure (10) integrated on a semiconductor substrate (11) according to claim 2, **characterised in that** said conductive layer (26) is a metallic layer.

7. Structure (10) integrated on a semiconductor substrate (11) according to claim 1, **characterised in that** said conductive region (15) and said semiconductor substrate (11) have a different type of conductivity.

8. Process for manufacturing a structure (10) integrated on a semiconductor substrate (11) having at least one elementary Peltier cell, the process comprising the steps of forming, for each elementary Peltier cell:
- a conductive region (15) in the semiconductor substrate (11) being less resistive with respect to said semiconductor substrate (11),
- a first semiconductive region (19) projecting from said smeiconductor substrate (11) in electric contact with said conductive region (15),
- a second semiconductive region (23) projecting from said semiconductor substrate (11) in electric contact with said conductive region (15) and spaced from said first semiconductive region (19), said first semiconductive region (19) and said second semiconductive region (23) having different type of conductivity.

9. Process according to claim 8, **characterised in that** said first and second semiconductive region (19, 23) are formed by means of respective selective epitaxial growth steps.

10. Process according to claim 9, **characterised in that** before forming said first and second semiconductive regions (19, 23) an insulating layer (16) is formed for shielding said semiconductor substrate (11) external with respect to portions (18, 22) of semiconductor substrate (11) whereon said first and second semiconductive regions (19, 23) are grown.

11. Process according to claim 8, **characterised in that** said conductive region (15) is formed by means of a ionic implantation step and a successive diffusion step.

12. Process according to claim 8, **characterised in that** portions of a conductive layer (26) are formed in electric connection with said first and second semiconductive region (19, 23).

13. Process according to claim 12, comprising the step of forming a plurality of elementary Peltier cells, **characterised in that** said portions of said conductive layer (26) are formed for connecting first semiconductive regions (19) which contact first conductive regions (15) to second semiconductive regions (23) which contact second adjacent conductive regions (15) to said first conductive regions (19).

14. Process according to claim 12, **characterised in that** said conductive layer (26) is formed by a metallic layer.

15. PCR structure (28) integrated on a semiconductor substrate (11) having a plurality of pits (29) on a first face of said semiconductor substrate (11) **characterised in that** a structure (10) formed according to any claim 1 to 14 is formed on a second surface of said semiconductor substrate (11).
